# EUROPEAN PATENT SPECIFICATION

(11) **EP 3 244 454 B1**
(45) Date of publication and mention of the grant of the patent: **03.05.2023**
(21) Application number: 15876420.9
(22) Date of filing: 08.07.2015
(51) Int. Cl.: H01L 31/0224, H01L 31/05, H01L 31/02, H01L 31/068, H01L 31/18, H01L 31/048

(54) **MAIN-GATE-FREE HIGH-EFFICIENCY BACK CONTACT SOLAR CELL AND ASSEMBLY AND PREPARATION PROCESS THEREOF**
HOCHEFFIZIENTE RÜCKSEITENKONTAKTIERTE SOLARZELLE OHNE MAIN-GATE, ANORDNUNG UND HERSTELLUNGSVERFAHREN
CELLULE SOLAIRE À CONTACT ARRIÈRE À HAUT RENDEMENT SANS GRILLE PRINCIPALE, ET SON PROCÉDÉ D'ASSEMBLAGE ET DE PRÉPARATION

(30) Priority: 05.01.2015 CN 201510002981
(43) Date of publication of application: 15.11.2017
(73) Proprietor: Jolywood(Suzhou) Sunwatt Co., Ltd, Changkun Industrial Zone Changshu City Jiangsu 215542 (CN)
(72) Inventor: LIN, Jianwei, Changshu Jiangsu 215542 (CN); XIA, Wenjin, Changshu Jiangsu 215542 (CN); SUN, Yuhai, Changshu Jiangsu 215542 (CN)
(74) Representative: Plasseraud IP
(86) International application number: PCT/CN2015/000347
(87) International publication number: WO 2016/109909

(56) References cited:
- EP-A1- 2 709 162
- EP-A1- 2 966 693
- WO-A1-2011/011855
- WO-A1-2011/011855
- CN-A- 102 184 976
- CN-A- 104 253 169
- CN-A- 104 576 778
- CN-U- 203 859 122
- CN-U- 204 348 742
- US-A1- 2011 146 747
- US-A1- 2011 174 355
- US-A1- 2014 166 102

## Description

### TECHNICAL FIELD

The present application relates to the field of solar cells, and in particular to a busbar-free and high-efficiency back-contact solar cell module, a busbar-free and high-efficiency back-contact solar assembly, and a preparation process thereof.

### BACKGROUND

Energy is the material basis of human activities. With the continuous development and progress of society, the demand for energy is increasing. The traditional fossil energy, belonging to non-renewable energy, has been difficult to meet the demands of the social development. Therefore, in recent years, new energy and renewable energy have been widely researched and utilized in countries all over the world. Among others, the solar power generation technology has attracted much attention due to its advantages of capability of directly converting sunlight into electric power, easy operation, environmental protection and no pollution, and high energy utilization. Solar power generation is a process of power generation in which large-area P-N junction diodes are used to produce photon-generated carriers under the radiation of sunlight.

Solar energy is enormous energy released by hydrogen nucleus in the sun during fusion at an ultrahigh temperature. Majority of energy required by the human being is directly or indirectly from the sun. Fossil fuels such as coal, petroleum and natural gas needed for life are formed by converting solar energy into chemical energy by various plants through photosynthesis, then storing the chemical energy into the plants and inheriting from the animals and plants buried underground over a long span of geological time. In addition, water energy, wind energy, tidal energy, ocean current energy and the like are also converted from the solar energy. The solar energy irradiated on the earth is so huge that irradiation on the earth about 40 minutes produces solar energy in an amount that is enough for one year of energy consumption for people all over the world. It seems that the solar energy is really inexhaustible and renewable energy, and the power generation from the solar energy is absolutely safe and pollution-free.

In the prior art, for dominant and highly commercial crystalline silicon solar cells, the emitter region and electrodes in the emitter region are all on the front side (light-facing side) of the cell. That is, the main gate line and the auxiliary gate line are both on the front side of the cell. Since solar-grade silicon material has a short diffusion distance, placing the emitter region on the front side is helpful for improving the collection efficiency of carriers. However, since the gate lines on the front side of the cell shield part of sunlight (about 8%), the effective light-receiving area of the solar cell is reduced and part of current is thus lost. In addition, when cells are connected in series to each other, a tin-plated copper band is to be welded from the front side of one cell to the back side of another cell. If a thick tin-plated copper band is used, it may be possible to crack the cell because of its excessive hardness. However, if a thin but wide tin-plated copper band is used, much sunlight may be shielded. Therefore, the loss resulted from the series connection of resistors and the optical loss will be caused regardless of the type of the tin-plated copper band used. Also, the use of the tin-plated copper band is disadvantageous to the thinning of the cell. To solve the above technical problems, by moving electrodes on the front side to the back side of the cell, those skilled in the art have developed a busbar-free back-contact solar cell. A back-contact solar cell is a solar cell in which electrodes in the emitter region and electrodes in the base region of the cell are all on the back side of the cell. Such a back-contact cell has many advantages. Firstly, high efficiency: since the loss resulted from the light shielding by the gate line electrodes on the front side is completely eliminated, the efficiency of the cell is improved. Secondly, the thinning of the cell can be realized. Since metallic connection devices used for series connection are all on the back side of the cell and there is no connection from the front side to the back side, a thinner silicon wafer can be used and the cost can be thus reduced. Thirdly, it is more beautiful and the color of the front side of the cell is uniform. The aesthetic requirements of the customers are satisfied.

The back-contact solar cells comprise many structures, for example, MWT, EWT and IBC. How to connect back-contact solar cells in series to form a solar cell assembly in high efficiency and at low cost is the key to realize highly commercial production of the back-contact solar cells. A conventional method for preparing an MWT assembly is to prepare conductive backing composite plate, apply conductive adhesive on the conductive backing plate, punch packaging material at a corresponding position so that the conductive adhesive penetrates through the packaging material, accurately place the back-contact solar cell on the packaging material so that conductive points on the conductive backing plate come into contact with electrodes on the back-contact solar cell by the conductive adhesive, and then pave an upper layer of EVA and glass on the cell, and finally overturn the whole well-stacked module and put it into a laminating press for lamination. This process has the following several shortcomings. Firstly, the used conductive backing composite plate is obtained by compositing conductive metal foil, usually copper foil, to the backing material, and it is required to perform laser etching or chemical corrosion on the copper foil. Since laser etching is slow in etching complex patterns although feasible for simple patterns, the production efficiency is low. And, with regard to chemical corrosion, it is required to prepare masks with complex shape and corrosion resistance property in advance, and the chemical corrosion also cause environmental pollution and corrosion to polymeric base material by the corrosive liquid. The conductive backing plate prepared in this way is complex in preparation process and extremely high in cost. Secondly, it is required to punch the packaging material behind the solar cell so that the conductive adhesive penetrates through the packaging material. Since the packaging material is usually viscoelastic material, it is difficult to perform precise punching. Thirdly, a precise dispensing apparatus is required to coat the conductive adhesive to the corresponding position of the backing plate. It is feasible for MWT cells with less back contacts. In contrast, for back-contact cells such as IBC with a large amount of back contacts each having a small area, it is impossible.

In the IBC technology, since the P-N junctions are placed on the back side of the cell, without any shield on the front side, and meanwhile, the electron collection distance is reduced, the efficiency of the cell can be significantly improved. For IBC cells, shallow diffusion, light doping, SiO₂ passivation layers, etc., are used on the front side to reduce the compositing loss, while on the back side of the cell, the diffusion regions are limited within a small region. Those diffusion regions are arranged in a lattice on the back side of the cell. Metallic contacts in the diffusion regions are limited within a very small area, appearing as a great number of small contacts. With regard to IBC cells, since the area of heavy diffusion regions on the back side of the cell is reduced, the saturation dark current in the doped region can be greatly reduced, and the open-circuit voltage and the conversion efficiency can be improved. Meanwhile, collecting current by a great number of small contacts reduces the transfer distance of the current on the back side and greatly decreases the internal series resistance of the assembly.

IBC back-contact cells have attracted much attention since they provide for high efficiency which is difficult to realize for the conventional solar cells, and have become a research hotspot of a new generation of solar cell technology. However, in the prior art, the P-N junctions in the IBC solar cell modules are positioned adjacent or close to each other and all on the back side of the cell. Accordingly, it is difficult to connect the IBC cell modules in series to form an assembly. In order to solve the above problem, there have been many improvements to the busbar-free back-contact IBC solar cells in the prior art. In Sunpower Corp., the adjacent P or N emitters are connected by small gate lines obtained from silver paste by screen printing so that the current is guided to the edge of the cell; and big solder joints are printed on the edge of the cell, and then welded and connected in series by a connection band. Since the development of screen printing, for mainstream products in the solar energy field, busbars for the current are usually formed by screen printing, for example, the newly applied patents 201410038687.8, 201410115631.8.

However, using small gate lines to collect current is feasible for 5-inch cells. But for 6-inch or bigger silicon wafers that are popular in the prior art, problems such as the rise of the series resistance and the reduction of the filling factor may occur. Consequently, the power of the manufactured assembly is significantly decreased. For IBC cells in the prior art, wider gate lines made of silver paste can be formed between the adjacent P or N emitters by screen printing to reduce the series resistance. However, the increase of the silver amount causes the sharp increase of the cost, and meanwhile, wide gate lines result in deteriorated insulating effect between P and N emitters and easy current leakage.

Patent US20110041908 A1 disclosed a back-contact solar cell having, on its back side, elongated emitter regions and base regions which are interleaved, and a method for producing the same. The back-contact solar cell has a semiconductor substrate; elongated base regions and elongated emitter regions are provided on the surface of the back side of the semiconductor substrate, the base regions having a base semiconductor type, and the emitter regions having an emitter semiconductor type opposite to the base semiconductor type; the elongated emitter regions have elongated emitter electrodes for electrically contacting the emitter regions, and the elongated base regions have elongated base electrodes for electrically contacting the base regions, wherein the elongated emitter regions have smaller structural widths than the elongated emitter electrodes, and wherein the elongated base regions have smaller structural widths than the elongated base electrodes. However, it is necessary to provide a large number of conducting members to effectively collect the current. Therefore, the manufacturing cost is increased, and the process steps are complex.

Patent EP2709162A1 disclosed a solar cell, used in a back-contact solar cell, and disclosed electrode contact units which are spaced apart from each other and arranged alternately. The electrode contact units are contact islands (blocky contacts), and the width of the blocky contacts is defined as 10 µm to 1 mm. The electrode contact units are connected by longitudinal connectors. However, this structure forms two connections on the cells. The first connection is to connect the cells to the electrode contact units, and the second connection is to connect the electrode contact units by connectors. The two connections result in complex process and too many electrode contacts. As a result, "disconnection" or "misconnection" may be caused. This is disadvantageous to the overall performance of the back-contact solar cell.

Patent WO2011143341A2 disclosed a back-contact solar cell, comprising a substrate; several adjacent P-type doping layers and N-type doping layers are located on the back side of the substrate; the P-type doping layers and the N-type doping layers are stacked with a metallic contact layer, and a passivation layer is provided between the P-type doping layers and N-type doping layers and the metallic contact layer; and a great number of nano-level connection holes are formed on the passivation layer, and the nano-level connection holes connect the P-type doping layers and N-type doping layers to the metallic contact layer. However, in this invention, connecting the metallic contact layer by nano-level holes will increase the resistance, the preparation process is complex, and high requirements are proposed to the preparation apparatus. In this invention, it is unable to integrate a number of solar cells and the electrical connection layer to one module. The integration of cells into solar cell modules is convenient to assemble the solar cell modules into an assembly, and also convenient to adjust the series/parallel connection between the modules. In this way, it can be convenient to adjust the series/parallel connection between cells in the solar cell modules, and reduce the connection resistance of the assembly.

Patent application EP2966693 A1 disclosed: a solar cell module includes a plurality of solar cells each including a semiconductor substrate, first electrodes positioned on a front surface of the semiconductor substrate, and second electrodes positioned on a back surface of the semiconductor substrate, and a plurality of wiring members connecting the first electrodes of a first solar cell of the plurality of solar cells to the second electrode of a second solar cell adjacent to the first solar cell. At least a portion of the first electrodes includes first pads each having a width greater than a width of the first electrode at crossings of the wiring members and the first electrodes. A size of at least one of the first pads is different from a size of the remaining first pads.

Patent application US 2011/146747 A1 disclosed: the cell to cell soldering and other soldered connections are replaced by electro and/or electroless plating. Back contact solar cells, diodes and external leads can be first laminated to the module front glass for support and stability. Conductive materials are deposited selectively to create a plating seed pattern for the entire module circuit. Subsequent plating steps create an integrated cell and module metallization.

Patent application US 2011/174355 A1 disclosed: A solar cell, in particular for connecting to a solar cell module, including at least one metallic base contact, at least one metallic emitter contact (5) and a semi-conductor structure having at least one base area and at least one emitter area (3). The base area and emitter area (2,3) are at least partially adjacent to each other forming a pn-junction, the base contact (6) being connected in an electrically conductive manner to the base area (2), the emitter contact (5) being connected in an electrically conductive manner to the emitter area (3), and the solar cells being arranged on the contact side (1) as a base and emitter contact (6,5).

In conclusion, if current collection is performed by using small gate lines, problems such as the rise of the series resistance and the reduction of the filling factor may occur. Consequently, the power of the manufactured assembly is significantly decreased. Wider gate lines made of sliver paste by screen printing will reduce the series resistance. However, the increase of the silver amount causes the sharp increase of the cost, and meanwhile, wide gate lines result in deteriorated insulating effect between P and N emitters and easy current leakage. If conductive particles of a back-contact solar cell are collected by metal leads only, since the thickness of the common solar cell is only 180 µm, in order to realize accurate positioning, generally, a tension needs to be applied for welding during welding the metal leads. In this case, thin silicon wafers will suffer a longitudinal stress from the leads and are thus likely to bend. Moreover, if the whole string of the solar cell is connected in series by a same lead, the difficulty of series connection and the probability of "misconnection" will be increased, and the thinning of the solar cell is hindered (as long as the theoretical thickness of the solar cell is 45 µm).

### SUMMARY

In view of shortcomings in the prior art, an objective of the present application is to provide a busbar-free and high-efficiency back-contact solar cell module, a busbar-free and high-efficiency back-contact solar cell assembly, and a preparation process thereof, which have simple structure, assembly convenience for cells, low cost, low series resistance, high cracking resistance, high efficiency, high stability and low stress.

Main technical solutions for the busbar-free and high-efficiency back-contact solar cell module provided by the present application are as follows.

The invention provides a busbar-free and high-efficiency back-contact solar cell module as defined by the subject-matter of claim 1, comprising solar cells and an electrical connection layer, a backlight side of the solar cells having P-electrodes connected to a P-type doping layer and N-electrodes connected to an N-type doping layer, wherein the electrical connection layer comprises a number of small conductive gate lines, part of which are connected to the P-electrodes on the backlight side of the solar cells while the other part of which are connected to the N-electrodes on the backlight side of the solar cells; and, the small conductive gate lines are of a multi-section structure.

The small conductive gate lines are interdigitally arranged in parallel.

An insulating medium capable of preventing the electrodes from turning on might be provided between the P-electrodes and the N-electrodes of the solar cells, between the electrodes in the doping layers of the cells and the small conductive gate lines or between the small conductive gate lines.

The P-electrodes are dotted P-electrodes, and the N-electrodes are dotted N-electrodes; and, there are 2 to 17 dotted electrodes interconnected by each conductive gate line In an embodiment, the diameter of the dotted P-electrodes is 0.2 mm to 1.5 mm, the distance between two adjacent dotted P-electrodes connected to a same small conductive gate line is 0.7 mm to 10 mm, and the width of the linear P-electrodes is 0.4 mm to 1.5 mm; the diameter of the dotted N-electrodes is 0.2 mm to 1.5 mm, the distance between two adjacent dotted N-electrodes connected on a same small conductive gate line is 0.7 mm to 10 mm, and the width of the linear N-electrodes is 0.4 mm to 1.5 mm; and, the total number of the dotted P-electrodes and the dotted N-electrodes is 1000 to 40000.

The dotted electrodes are made of any one of sliver paste, conductive adhesive, conductive polymeric material or tin solder.

The small conductive gate lines are made of sintered silver paste or leads, and each of the small conductive gate lines has a width of 10 µm to 300 µm and a width-to-height ratio of 1:0.01 to 1:1.

In an embodiment there are 2, 3, 5, 7, 9, 11, 13, 15 or 17 dotted or linear electrodes interconnected by each conductive gate line.

Leads are provided in the electrical connection layer; the leads connect the P-electrodes; and the leads connect the N-electrodes.

In an embodiment the leads are vertically connected to a center line of the number of small conductive gate lines.

The leads and the small conductive gate lines form " 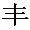 "-shaped structures, which are arranged crosswise.

In an embodiment surfaces of the leads are plated with anti-oxidation plating material or coated with a conductive adhesive; the anti-oxidation plating material is any one of tin, tin-lead alloy, tin-bismuth alloy or tin-lead-silver alloy; the plating layer or conductive adhesive layer of the leads has a thickness of 5 µm to 50 µm; the conductive adhesive is a low-resistivity conductive adhesive that uses a conductive particle and a polymeric binder as main components; the conductive particle in the conductive adhesive is any one or more of gold, silver, copper, gold-plated nickel, silver-plated nickel or silver-plated copper, the shape of the conductive particles are any one of a spherical shape, a flake shape, an olivary shape or an acicular shape, and the particle size of the conductive particle is 0.01 µm to 5 µm; and, the polymeric binder in the conductive adhesive is any one or more of epoxy resin, polyurethane resin, acrylic resin or organic silicon resin, and the binder is thermosetting or photocureable.

In an embodiment electrical connection layer is provided with P-busbar electrodes and N-busbar electrodes, which are arranged on two sides of the electrical connection layer; and, the surface of the busbar electrodes has a concavo-convex shape.

In an embodiment insulating medium is a thermoplastic resin or a thermosetting resin, and the resin is any one or more of polyimide, polycaprolactam, polyolefin resin, epoxy resin, polyurethane resin, acrylic resin and organic silicon resin.

Main technical solutions for the busbar-free and high-efficiency back-contact solar cell assembly provided by the present application are as follows.

A busbar-free and high-efficiency back-contact solar cell assembly is provided, comprising fronting material, packaging material, a solar cell layer, packaging material and backing material, which are connected from top to bottom, wherein the solar cell layer comprises a number of solar cell modules, and the solar cell modules refer to the solar cell module according to the above technical solutions.

The busbar-free and high-efficiency back-contact solar cell assembly provided by the present application may further comprise the following technical solutions.

The solar cell modules in the solar cell layer are connected via busbars arranged on two sides of an electrical connection layer.

The number of solar cells in the solar cell assembly is 1 to 120.

The invention further provides a method for preparing a busbar-free and high-efficiency back-contact solar cell assembly as defined by the subject-matter of claim 13, comprising the following steps:
Step 1: connecting solar cell modules as defined in claim 1 in series to form a solar cell layer electrically connecting a number of leads to electrodes or small conductive gate lines of a first solar cell, and aligning a second solar cell with the first solar cell so that P-electrodes on the second solar cell and N-electrodes on the first solar cell are on a same lead; and, electrically connecting the leads to electrodes or small conductive gate lines of the second solar cell, and repeating the above operations to form a series connection structure, so as to form a solar cell layer; and
Step 2: successively stacking and laminating fronting material, packaging material, the solar cell layer, packaging material and backing material to obtain a solar cell assembly.

The method for preparing a busbar-free and high-efficiency back-contact solar cell assembly provided by the present application may further comprise the following technical solutions.

A solar cell string is prepared in accordance with the Step 1, and the solar cell string comprises at least one solar cell; and, busbar electrodes are arranged on two sides of the solar cell string, and the busbar electrodes are connected in series to form a solar cell layer.

A process for preparing the small conductive gate lines is as follows: printing silver paste on the solar cells in segments by screen printing, drying small gate lines of the solar cells having silver paste electrodes printed thereon, and sintering as a whole to obtain a solar cell module with a number of small conductive gate lines.

Parameters for the laminating operation are set according to the vulcanizing properties of the packaging material; and, the packaging material is EVA and the parameters for the laminating operation are as follows: laminating 9 to 35 min at 120°C to 180°C.

The solar cells and the leads in the Step 1 are electrically connected by coating conductive adhesive on a P-type doping layer and an N-type doping layer on the cells by screen printing; the conductive adhesive, when heated, can be solidified to form the P-electrodes and the N-electrodes; and, when heated, the leads and the P-electrodes or the N-electrodes come into Ohm contact by the conductive adhesive, and in this way, the leads and the cells are electrically connected; the solar cells and the leads can also be electrically connected by plating low-melting-point material on the leads by a plating process; when heated, the leads and the P-type doping layer or the N-type doping layer are welded by the melting of the low-melting-point material to form the P-electrodes and the N-electrodes, and in this way the leads and the solar cells are electrically connected; and the low-melting-point material is any one of tin solder, tin-lead alloy, tin-bismuth alloy or tin-lead-silver alloy; and
the solar cells and the leads can also be electrically connected by laser welding.

The implementations of the present application have the following technical effects.

Firstly, in the present application, numerous dotted electrodes on a backlight side of solar cell are centralized properly, so that the difficulty of series connection between cells is reduced and it is advantageous for industrial production. Since an aluminum side may be omitted, the cost is reduced. Particularly, in the implementations of the present application, the amount of silver paste is decreased, and the cost is reduced. Moreover, the arrangement of small conductive gate lines in a multi-section structure reduces the series resistance and the transmission distance of the electrons, so that the efficiency is improved and the stress on the cells from the small conductive gate lines can be effectively reduced. In the present application, due to the presence of multiple " T- "-shaped structures, the stress is dispersed. Consequently, the stress on the cells from the leads is reduced, the cells will not be deformed, and it is advantages for the thinning of cell silicon wafers.

Secondly, in the present application, the thinning of the cell can be realized. Since metallic connection devices used for series connection are all on the back side of the cell and the connection from the front side to the back side in the past is eliminated, smaller metallic connection devices can be used for series connection, a thinner silicon wafer can be used and the cost can be thus reduced.

Thirdly, the back-contact solar cell of the present application is generally applicable to various structures such as MWT, EWT and IBC, and is thus highly practicable.

Fourthly, a photovoltaic system integrated by the assembles produced by the technology of the present application can completely avoid the problem of significant reduction of current of the whole string, which is because that certain current is lost due to the cracking of one cell. Thus, the whole system is highly tolerant to hidden-cracks and micro-cracks caused during the production, transportation, assembling and using processes, and shows great overall performance.

Fifthly, the multi-point and decentralized contact between the solar cell electrodes and the metallic connection devices in the present application reduces the electron collection distance and greatly decreases the series resistance of the assembly.

Sixthly, since the back-contact solar cell of the present application needs no main gate, the amount of silver paste is greatly reduced so that the manufacturing cost of the back-contact cell is significantly reduced. Since the back-contact solar cell of the present application needs no silver paste main gate, the amount of silver paste is greatly reduced so that the manufacturing cost of the back-contact cell is significantly reduced. Moreover, since both the conversion efficiency and the assembly efficiency are high, the loss resulted from the shielding by gate line electrodes on the front side is eliminated, and the efficiency of the cell is thus improved. In the present application, the multi-point and decentralized contact between the solar cell electrodes and the electrical connection layer in the present application reduces the electron collection distance and greatly decreases the series resistance of the assembly. The thinning of the cell can also be realized. Since metallic connection devices used for series connection are all on the back side of the cell and there is no connection from the front side to the back side, a thinner silicon wafer can be used and the cost can be thus reduced.

Seventhly, the cracking resistance is high. A photovoltaic system integrated by the assembles produced by the technology of the present application can completely avoid the problem of significant reduction of current of the whole string, which is because that certain current is lost due to the cracking of one cell. Since the multi-point connection between the conductors and the cells is realized by the busbar-free and high-efficiency multi-section small gate line technology proposed by the present application, the tolerance of the whole system to hidden-cracks and micro-cracks caused during the production, transportation, assembling and using processes can be improved. The arrangement of the small conductive gate lines can reduce the migration distance of electrons and holes and enhance the capability of cells to collect electrons.

In an assembly prepared by this technology, the back-contact cells and the conductors are in multi-point connection, and the connection points are distributed more intensively, up to thousands or even tens of thousands of connection points. In portions where hidden-cracks and micro-cracks are found on the silicon wafer, the current conduction path is further optimized. Therefore, since the loss resulted from cracks is greatly reduced, the quality of products is improved. Usually, in a photovoltaic system, when hidden-cracks occur on a cell, the upper region of the cell will be separated from the main gate, and consequently, current generated in this region cannot be collected. In a photovoltaic system, the cells are connected in series to form a matrix, and thus this system exhibits obvious bucket effect. When hidden-cracks occur on one cell and certain current is thus lost, the current of the whole string will be significantly decreased. As a result, the power generation efficiency of the whole string is drastically decreased. A photovoltaic system integrated by assembles produced by the technology of the present application can completely avoid such problems. Since the multi-point connection between the conductors and the cells is realized by the busbar-free and high-efficiency multi-section small gate line technology proposed by the present application, the whole photovoltaic system is highly tolerant to hidden-cracks and micro-cracks caused during the production, transportation, assembling and using processes. This can be explained by a simple example. A solar assembly produced by the conventional technologies is just like a common piece of glass which as a whole is broken when only one point is crushed. However, an assembly produced by the busbar-free and high-efficiency multi-section small gate line technology is just like a piece of laminated glass which, as a whole, still functions to keep out wind and rain even it looks not so beautiful when one point is crushed. This technology breaks through the conventional cell stringing process, by which the cells are arranged more freely and intensively. An assembly produced by this technology is expected to be smaller and lighter. For the development of downstream programs, it means smaller area for mounting, lower roof bearing requirements, and less manpower. By the busbar-free back-wiring technology, low-cost and high-efficiency connection of back-contact solar cells can be realized. The replacement of silver main gates with copper wires reduces the cost, so that the real industrial and large-scale production of back-contact solar cells is realized. This reduces the cost while improving the efficiency, and provides, for the photovoltaic system, photovoltaic assemblies with higher efficiency, lower cost, better stability and more excellent hidden-crack resistance performance. The competitiveness of photovoltaic systems relative to the conventional energy is greatly improved.

### BRIEF DESCRIPTION OF THE DRAWINGS

Fig. 1 is a schematic view of the back side of busbar-free and high-efficiency back-contact solar cell module comprising a first dotted solar cell (Embodiment 1);
Fig. 2 is a schematic view of the back side of busbar-free and high-efficiency back-contact solar cell module comprising a second dotted solar cell (Embodiment 1);
Fig. 3 is a cross-sectional view of a lead (Fig. 3a is a cross-sectional view of a lead having a single material layer, Fig. 3b is a cross-sectional view of a lead having two material layers and Fig. 3c is a cross-sectional view of a lead having three material layers);
Fig. 4 is a schematic view of the series connection of dotted solar cells forming busbar-free and high-efficiency back-contact solar cell modules (Embodiment 1);
Fig. 5 is a schematic view of the back side of busbar-free and high-efficiency back-contact solar cell module corresponding to a third dotted solar cell(Embodiment 2);
Fig. 6 is a schematic view of the back side of busbar-free and high-efficiency back-contact solar cell module comprising a fourth dotted solar cell (Embodiment 2);
Fig. 7 is a schematic view of the series connection of dotted solar cells forming busbar-free and high-efficiency back-contact solar cell modules (Embodiment 2);
Fig. 8 is a schematic view of the back side of busbar-free and high-efficiency back-contact solar cell module comprising a linear solar cell; and
Fig. 9 is a schematic view of a busbar-free and high-efficiency back-contact solar cell assembly,
   in which:
   1: solar cell; 2: dotted P-electrode; 21: linear P-electrode; 3: dotted N-electrode; 31: linear N-electrode; 4: small conductive gate lines between P-electrodes; 5: small conductive gate lines between N-electrodes; 6: insulating medium; 7: lead; 71: metal material such as copper, aluminum or steel; 72: metal material different from 1, such as aluminum or steel; 73: tin, tin-lead, tin-bismuth, or tin-lead-silver alloy solder; 8: first solar cell; 81: second solar cell; 9: third solar cell; 91: fourth solar cell; 10: P-busbar electrode; and, 11: N-busbar electrode.

### DETAILED DESCRIPTION

The present application will be described below in detail by embodiments with references to the accompanying drawings. It is to be noted that the described embodiments are merely for understanding the present application and not intended to limit the present application.

### Embodiment 1

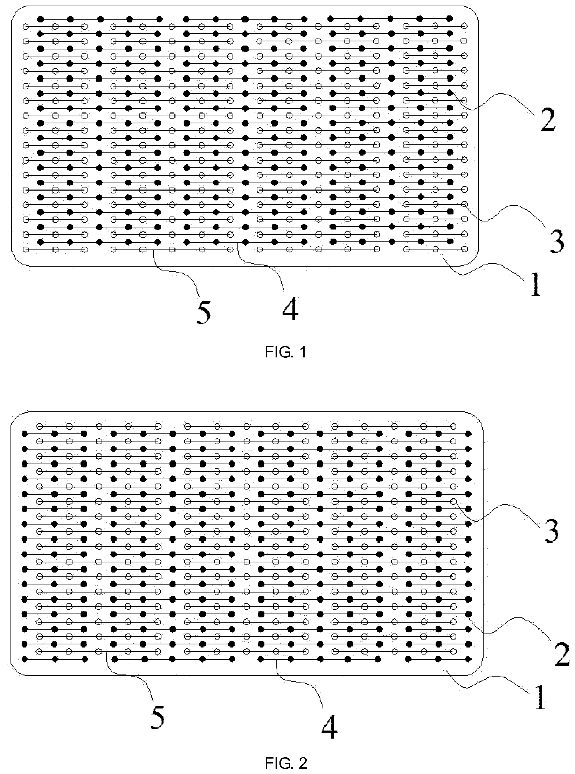

Referring to Figs. 1, 2 and 4, a busbar-free and high-efficiency back-contact solar cell module is provided, comprising solar cells 1 and an electrical connection layer, a backlight side of the solar cells 1 having P-electrodes connected to a P-type doping layer and N-electrodes connected to an N-type doping layer, wherein the electrical connection layer comprises a number of small conductive gate lines, part of which are connected to the P-electrodes on the backlight side of the solar cells 1 while the other part of which are connected to the N-electrodes on the backlight side of the solar cells 1; and the small conductive gate lines are of a multi-section structure.

Fig. 1 shows a first busbar-free and high-efficiency back-contact solar cell 8, wherein there are 15 rows of dotted P-electrodes 2 and 16 dotted P-electrodes 2 in each row, total 240 dotted P-electrodes 2; and, there are 16 rows of dotted N-electrodes 3 and 16 dotted N-electrodes 3 in each row, total 256 dotted N-electrodes 3. The diameter of the dotted P-electrodes 2 is 0.2 mm to 1.5 mm, and the distance between two adjacent dotted P-electrodes 2 connected to a same small conductive gate line is 0.7 mm to 10 mm. The diameter of the dotted N-electrodes 3 is 0.2 mm to 1.5 mm, and the distance between two adjacent dotted N-electrodes 3 connected to a same small conductive gate line is 0.7 mm to 10 mm. In this embodiment, preferably, the diameter of the dotted P-electrodes 2 is 0.9 mm, and the distance between two adjacent dotted P-electrodes 2 connected to a same small conductive gate line is 10 mm; and, the diameter of the dotted N-electrodes 3 is 0.8 mm, the distance between two adjacent dotted N-electrodes 3 connected to a same small conductive gate line is 10 mm, and the center distance between a connection line of the dotted P-electrodes 2 and a connection line of the dotted N-electrodes 3 is 10 mm. The small conductive gate lines are interdigitally arranged in parallel. The number of dotted electrodes interconnected by each conductive gate line may be 2, 3, 5, 7, 9, 11, 13, 15 or 17, preferably 5 in this embodiment. Every five dotted P-electrodes 2 are connected by the small conductive gate lines. The small conductive gate lines are made of sintered silver paste or leads, preferably sintered silver paste in this embodiment. Each of the small conductive gate lines has a width of 10 µm to 300 µm and a width-to-height ratio of 1:0.01 to 1:1. In this embodiment, preferably, each of the small conductive gate lines has a width of 30 µm. Three leftmost dotted N-electrodes 3 are connected by a small conductive gate line which is made of sintered silver paste and has a width of 30 µm. Five middle dotted N-electrodes 3 are also connected by a same small conductive gate line. Three rightmost dotted N-electrodes 3 are also connected by a same small conductive gate line. The conversion efficiency of the cell is 23.2%.

Fig. 2 shows a second busbar-free and high-efficiency back-contact solar cell 81, wherein there are 15 rows of dotted N-electrodes 3 and 16 dotted N-electrodes 3 in each row, total 240 dotted N-electrodes 3; and, there are 16 rows of dotted P-electrodes 2 and 16 dotted P-electrodes 2 in each row, total 256 dotted P-electrodes 2. The diameter of the dotted P-electrodes 2 is 0.2 mm to 1.5 mm, and the distance between two adjacent dotted P-electrodes 2 connected to a same small conductive gate line is 0.7 mm to 10 mm. The diameter of the dotted N-electrodes 3 is 0.2 mm to 1.5 mm, and the distance between two adjacent dotted N-electrodes 3 connected to a same small conductive gate line is 0.7 mm to 10 mm. In this embodiment, preferably, the diameter of the dotted P-electrodes 2 is 0.9 mm, and the distance between two adjacent dotted P-electrodes 2 connected to a same small conductive gate line is 10 mm; and, the diameter of the dotted N-electrodes 3 is 0.8 mm, and the distance between two adjacent dotted N-electrodes 3 connected to a same small conductive gate line is 10 mm, and the center distance between a connection line of the dotted P-electrodes 2 and a connection line of the dotted N-electrodes 3 is 10 mm. The small conductive gate lines are interdigitally arranged in parallel. The number of dotted electrodes interconnected by each conductive gate line may be 2, 3, 5, 7, 9, 11, 13, 15 or 17, preferably 5 in this embodiment. Every five dotted N-electrodes 3 are connected by the small conductive gate lines. The small conductive gate lines are made of sintered silver paste or leads, preferably sintered silver paste in this embodiment. Each of the small conductive gate lines has a width of 10 µm to 300 µm and a width-to-height ratio of 1:0.01 to 1:1. In this embodiment, preferably, each of the small conductive gate lines has a width of 30 µm. Three leftmost dotted P-electrodes 2 are connected by a small conductive gate line which is made of sintered silver paste and has a width of 30 µm. Five middle dotted P-electrodes 2 are also connected by a same small conductive gate line. Three rightmost dotted P-electrodes 2 are also connected by a same small conductive gate line. The conversion efficiency of the cell is 23.4%. In this embodiment, since numerous dotted electrodes on the backlight side of the solar cell 1 are centralized properly, the difficulty of series connection between cells is reduced, and it is advantageous for industrial production.

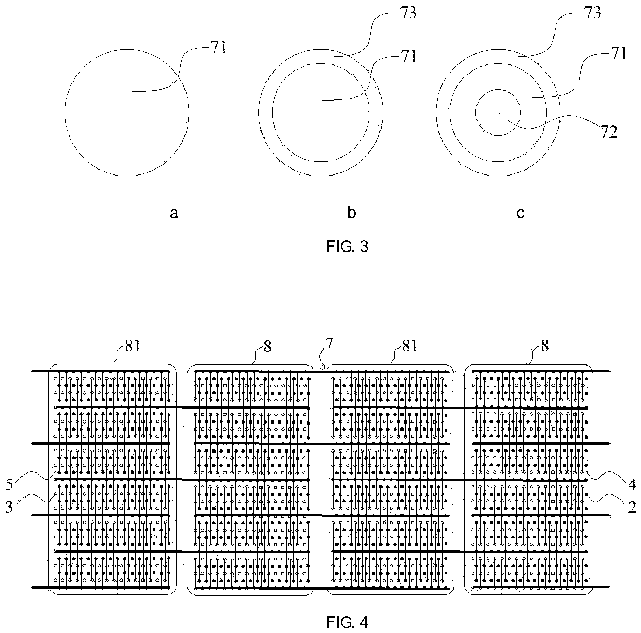

Fig. 4 shows a back schematic view of the series connection of dotted busbar-free and high-efficiency back-contact solar cells. Leads 7 are further provided on an electrical connection layer of the busbar-free and high-efficiency back-contact solar cell module. The leads 7 connect a number of small conductive gate lines connected to the P-electrodes or connect the P-electrodes, and the leads 7 connect a number of small conductive gate lines connected to the N-electrodes or connect the N-electrodes. A number of adjacent dotted P-electrodes 2 or dotted N-electrodes 3 converge the current by the small conductive gate lines, and the collected current is exported by the leads 7. Preferably, the leads 7 are vertically connected to a center line of the number of small conductive gate lines. The leads 7 and the small conductive gate lines form " 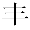 "-shaped structures or comb-finger structures, which are arranged crosswise. In the implementations of this embodiment, the amount of silver paste is reduced, and the cost is reduced. Moreover, the arrangement of small conductive gate lines in a multi-section structure reduces the series resistance and the transmission distance of the filling factor, so that the efficiency is improved and the stress on the cells from the leads 7 can be effectively reduced. In the present application, due to the presence of multiple "T-"-shaped structures, the stress is dispersed. Consequently, the stress on the cells from the leads 7 is reduced, and it is advantages for the thinning of cell silicon wafers.

Preferably, an insulating medium 6 capable of preventing the electrodes from turning on is provided between the P-electrodes and the N-electrodes on the backlight side of the solar cells 1, between the electrodes in the doping layers of the cells and the small conductive gate lines, between the small conductive gate lines or at junctions of the small conductive gate lines and the leads. The insulating medium 6 is a thermoplastic resin or a thermosetting resin. The resin is any one or two of polyimide, polycaprolactam, polyolefin resin, epoxy resin, polyurethane resin, acrylic resin and organic silicon resin. This resin, on one hand, can isolate the electrodes in the emitter region and the electrodes in the base region, and on the other hand, can bond the back-contact solar cells 1 and the packaging material together during the laminating operation.

In this embodiment, the leads 7 may be any one of Fig. 3. Fig. 3a shows a cross-sectional view of a lead having a single material layer, Fig. 3b shows a cross-sectional view of a lead having two material layers, and Fig. 3c shows a cross-sectional view of a lead having three material layers. The leads used in this embodiment are plated leads 7 having three structural layers, including an innermost layer of leads having a diameter of 0.8 mm, an intermediate copper layer having a thickness of 0.2 mm, and an outermost tin-plated layer having a thickness of 0.3 mm. The plated leads have a circular cross-section and a diameter of 1.3 mm.

Preferably, the surfaces of the leads 7 are plated with anti-oxidation plating material or coated with a conductive adhesive. The anti-oxidation plating material is any one of tin, tin-lead alloy, tin-bismuth alloy or tin-lead-silver alloy. The plating layer or conductive adhesive layer of the leads 7 has a thickness of 5 µm to 50 µm. The conductive adhesive is a low-resistivity conductive adhesive that uses a conductive particle and a polymeric binder as main components. The conductive particle in the conductive adhesive is any one or more of gold, silver, copper, gold-plated nickel, silver-plated nickel or silver-plated copper. The shape of the conductive particles is any one of a spherical shape, a flake shape, an olivary shape or an acicular shape, and the particle size of the conductive particle is 0.01 µm to 5 µm. The polymeric binder in the conductive adhesive is any one or two of epoxy resin, polyurethane resin, acrylic resin or organic silicon resin, and the binder is thermosetting or photocureable.

This embodiment further provides a busbar-free and high-efficiency back-contact solar cell assembly, comprising fronting material, packaging material, a solar cell layer, packaging material and backing material, which are connected from top to bottom, wherein the solar cell layer comprises a number of solar cell modules, and the solar cell modules refer to the solar cell module according to the above embodiment.

A preparation method of the busbar-free and high-efficiency back-contact solar cell assembly may be realized in the following ways. Firstly, solar cells 1 comprising a number of multi-section small gate lines are connected in series, then guided out by a group of P-busbar electrodes 10 and N-busbar electrodes 11, and laminated to obtain a solar cell assembly. Secondly, a solar cell electrical connection layer comprising of multi-section small gate lines and leads 7are formed on a single cell; leads 7 connected to the N-electrodes are connected to N-busbar electrodes 11, and leads 7 connected to the P-electrodes are connected to P-busbar electrodes 10; and, the busbar electrodes are connected in series and then laminated to obtain a solar cell assembly. Thirdly, multi-section small gate lines and leads 7 are formed on at least two cells to form a solar cell string comprising of multiple solar cells; leads 7 connected to the N-electrodes are connected to N-busbar electrodes 11, and leads 7 connected to the P-electrodes are connected to P-busbar electrodes 10; and, the busbar electrodes of the solar cell string are connected in series and then laminated to obtain a solar cell assembly. The specific process is as follows.

A method for preparing a busbar-free and high-efficiency back-contact solar cell assembly is provided, comprising the following steps.

Step 1: Solar cell modules are connected in series to form a solar cell layer, an electrical connection layer on a backlight side of each of the solar cell modules having a number of small conductive gate lines connected to P-electrodes and a number of small conductive gate lines connected to N-electrodes, and the small conductive gate lines being of a multi-section structure; a number of leads 7 are electrically connected to P-electrodes or small conductive gate lines connected to the P-electrodes in a first solar cell 8, and a second solar cell 81 is aligned with the first solar cell 8 so that P-electrodes on the second solar cell 81 and N-electrodes on the first solar cell 8 are on a same lead 7; the leads 7 are electrically connected to N-electrodes or small conductive gate lines connected to the N-electrodes in the second solar cell 81 so that the second solar cell 81 and the first solar cell 8 are connected in series; and, the first solar cell 8 is placed, the leads 7 are electrically connected to the first solar cell 8, the above operations are repeated to form a series connection structure, so as to form a solar cell layer.

In this embodiment, the connection is realized by welding. In this embodiment, the leads 7 plated with low-melting-point material are used. The low-melting-point material is any one of tin solder, tin-lead alloy, tin-bismuth alloy or tin-lead-silver alloy. The plating process is any one of hot dip coating, electroplating or chemical plating, preferably tin solder electroplating in this embodiment. When heated, the leads 7 and the P-type doping layer or the N-type doping layer are welded by the melting of the low-melting-point material to form the P-electrodes and the N-electrodes, and in this way, the leads 7 and the solar cells are electrically connected. The temperature for welding is 300°C to 400°C, preferably 300°C in this embodiment. In the welding process, a heating pad can be used on the front side of the cell, in order to prevent the cell from breaking or hidden-cracking due to a big temperature difference on the two sides of the cell. The temperature of the heating pad is controlled at 40°C to 80°C, preferably 70°C in this embodiment. The heating way is any one or more of infrared radiation, heating by resistance wires or heating by hot wind, and the heating temperature is 150°C to 500°C, preferably 300°C in this embodiment. A process for preparing the small conductive gate lines is as follows: printing silver paste on the solar cells in segments by screen printing, drying small gate lines of the solar cells having silver paste electrodes printed thereon, and sintering as a whole to obtain a solar cell module with a number of small conductive gate lines.

In this embodiment, the connection may also be realized in the following way. The solar cells and the leads 7 in the Step 1 are electrically connected by coating conductive adhesive on a P-type doping layer and an N-type doping layer on the cells by screen printing; the conductive adhesive, when heated, can be solidified to form the P-electrodes and the N-electrodes; and, when heated, the leads 7 and the P-electrodes or the N-electrodes come into Ohm contact by the conductive adhesive, and in this way, the leads 7 and the cells are electrically connected.

The solar cells and the leads 7 can also be electrically connected by laser welding.

Step 2: The manufactured solar cell layers are connected in series by using conventional and general busbars having a cross-sectional area of 5× 0.22 mm. The number of the solar cells is selected as desired. In this embodiment, 32 solar cells are selected. Glass, EVA, the solar cell layer, EVA and backing material are successively stacked, and the appearance inspection is performed, wherein the well-stacked module is put into a laminating press for lamination, and parameters for the laminating operation are set according to the vulcanizing properties of the EVA, usually, laminating for 16 min at 145°C. At last, a metal frame and a terminal box are mounted on the laminated module, and then power test and appearance inspection are performed. Hence, the solar cell assembly is obtained.

The above back-contact assembly having 32 solar cells has the following power parameters:
open-circuit voltage: Uoc (V) 22.52;
short-circuit current: Isc (A) 9.33;
working voltage: Ump (V) 17.35;
working current: Imp (A) 9.22;
maximum power: Pmax (W) 159.97; and
filling factor: 76.13 %.

A method for preparing a busbar-free and high-efficiency back-contact solar cell assembly is provided, comprising the following steps.

Step 1: Solar cell modules are connected in series to form a solar cell layer, an electrical connection layer on a backlight side of each of the solar cell modules having a number of small conductive gate lines connected to P-electrodes and a number of small conductive gate lines connected to N-electrodes, and the small conductive gate lines being of a multi-section structure; a number of parallel leads 7 are straightened and then electrically connected to P-electrodes or small conductive gate lines connected to the P-electrodes in a first solar cell 8, and a second solar cell 81 is aligned with the first solar cell 8 so that P-electrodes on the second solar cell 81 and N-electrodes on the first solar cell 8 are on a same lead 7; the leads 7 are electrically connected to N-electrodes or small conductive gate lines connected to the N-electrodes in the second solar cell 81 so that the second solar cell 81 and the first solar cell 8 are connected in series; the first solar cell 8 is placed, the leads 7 are electrically connected to the first solar cell 8, and the above operations are repeated to form a series connection structure of 10 solar cells; N-busbar electrodes 11 and P-busbar electrodes 10 are provided on two sides of the solar cell string; and, the P-busbar electrodes 10 and the N-busbar electrodes 11 are connected in series to form a solar cell layer.

Step 2: A back-contact solar cell is manufactured, having six strings of solar cells, each string having ten solar cells, total sixty solar cells. Glass, EVA, the solar cell layers, EVA and backing material are successively stacked, and the appearance inspection is performed, wherein the well-stacked module is put into a laminating press for lamination, and parameters for the laminating operation are set according to the vulcanizing properties of the EVA, usually, laminating for 35 min at 120°C. At last, a metal frame and a terminal box are mounted on the laminated module, and then power test and appearance inspection are performed. Hence, a cell assembly is obtained.

The above back-contact assembly having 60 solar cells has the following power parameters:
open-circuit voltage: Uoc (V) 41.81;
short-circuit current: Isc (A) 9.31;
working voltage: Ump (V) 32.97;
working current: Imp (A) 9.12;
maximum power: Pmax (W) 300.68; and
filling factor: 77.26%.

### Embodiment 2

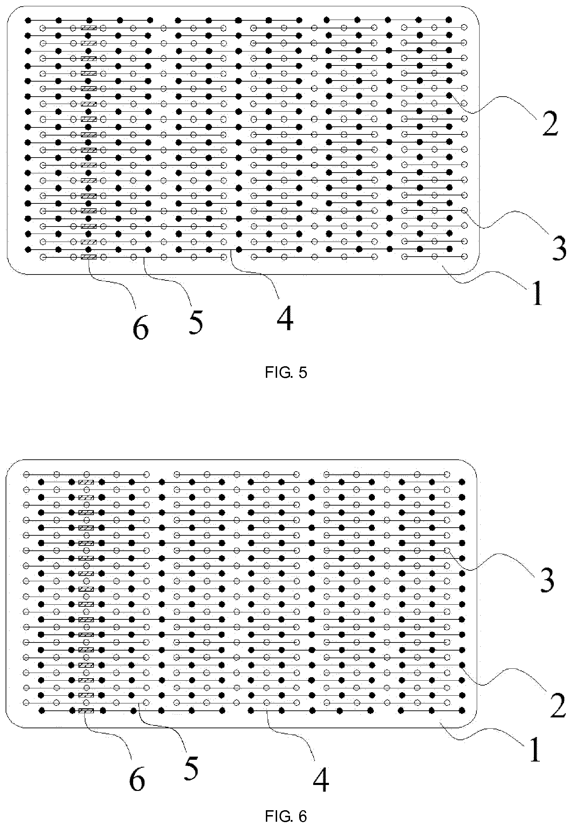

Referring to Figs. 5, 6 and 7, a busbar-free and high-efficiency back-contact solar cell module is provided, comprising at least one solar cell 1, an electrical connection layer comprising of leads 7 and small conductive gate lines. A backlight side of a silicon substrate of the solar cell 1 has P-electrodes connected to a P-type doping layer and N-electrodes connected to an N-type doping layer. The electrical connection layer on the backlight side of the solar cell 1 is provided with a number of small conductive gate lines connected to the P-electrodes and a number of small conductive gate lines connected to the N-electrodes. The small conductive gate lines are of a multi-section structure. An insulating medium 6 capable of preventing the small conductive gate lines and the leads 7 from turning on is provided at junctions of the small conductive gate lines and the leads 7.

Fig. 5 shows a third busbar-free and high-efficiency back-contact solar cell 9, wherein there are 15 rows of dotted P-electrodes 2 and 15 dotted P-electrodes 2 in each row, total 225 dotted P-electrodes 2; and, there are 15 rows of dotted N-electrodes 3 and 15 dotted N-electrodes 3, total 225 dotted N-electrodes 3. The diameter of the dotted P-electrodes 2 is 0.2 mm to 1.5 mm, and the distance between two adjacent dotted P-electrodes 2 connected to a same small conductive gate line is 0.7 mm to 10 mm. The diameter of the dotted N-electrodes 3 is 0.2 mm to 1.5 mm, and the distance between two adjacent dotted N-electrodes 3 connected to a same small conductive gate line is 0.7 mm to 10 mm. In this embodiment, preferably, the diameter of the dotted P-electrodes 2 is 1.5 mm, and the distance between two adjacent dotted P-electrodes 2 connected to a same small conductive gate line is 5 mm; and, the diameter of the dotted N-electrodes 3 is 1.5 mm, the distance between two adjacent dotted N-electrodes 3 connected to a same small conductive gate line is 5 mm, and the center distance between a connection line of the dotted P-electrodes 2 and a connection line between the dotted N-electrodes 3 is 5 mm. The small conductive gate lines are interdigitally arranged in parallel. The number of dotted electrodes interconnected by each conductive gate line may be 2, 3, 5, 7, 9, 11, 13, 15 or 17, preferably 3, 5 or 7 in this embodiment. Every five dotted P-electrodes 2 are connected by the small conductive gate lines. The small conductive gate lines are made of sintered silver paste or leads, preferably small conductive gate lines in this embodiment. Each of the small conductive gate lines has a width of 10 µm to 300 µm and a width-to-height ratio of 1:0.01 to 1:1. In this embodiment, preferably, each of the small conductive gate lines has a width of 300 µm. Seven leftmost dotted N-electrodes 3 are connected by a small conductive gate line which is made of sintered silver paste and has a width of 300 µm. Five middle dotted N-electrodes 3 are also connected by a same small conductive gate line. Three rightmost dotted N-electrodes 3 are also connected by a same small conductive gate line. An insulating medium 6 is further provided on the cell, and the conversion efficiency of the cell is 23.2%.

Fig. 6 shows a fourth busbar-free and high-efficiency back-contact solar cell 91, wherein there are 15 rows of dotted P-electrodes 2 and 15 dotted P-electrodes 2 in each row, total 225 dotted P-electrodes 2; and, there are 15 rows of dotted N-electrodes 3 and 15 dotted N-electrodes 3, total 225 dotted N-electrodes 3. The diameter of the dotted P-electrodes 2 is 0.2 mm to 1.5 mm, and the distance between two adjacent dotted P-electrodes 2 connected to a same small conductive gate line is 0.7 mm to 10 mm. The diameter of the dotted N-electrodes 3 is 0.2 mm to 1.5 mm, and the distance between two adjacent dotted N-electrodes 3 connected to a same small conductive gate line is 0.7 mm to 10 mm. In this embodiment, preferably, the diameter of the dotted P-electrodes 2 is 1.5 mm, and the distance between two adjacent dotted P-electrodes 2 connected to a same small conductive gate line is 5 mm; and, the diameter of the dotted N-electrodes 3 is 1.5 mm, the distance between two adjacent dotted N-electrodes 3 connected to a same small conductive gate line is 5 mm, and the center distance between a connection line of the dotted P-electrodes 2 and a connection line between the dotted N-electrodes 3 is 5 mm. The small conductive gate lines are interdigitally arranged in parallel. The number of dotted electrodes interconnected by each conductive gate line may be 2, 3, 5, 7, 9, 11, 13, 15 or 17, preferably 3, 5 or 7 in this embodiment. Every five dotted N-electrodes 3 are connected by the small conductive gate lines. The small conductive gate lines are made of sintered silver paste or leads, preferably small conductive gate lines in this embodiment. Each of the small conductive gate lines has a width of 10 µm to 300 µm and a width-to-height ratio of 1:0.01 to 1:1. In this embodiment, preferably, each of the small conductive gate lines has a width of 300 µm. Seven leftmost dotted P-electrodes 2 are connected by a small conductive gate line which is made of sintered silver paste and has a width of 300 µm. Five middle dotted P-electrodes 2 are also connected by a same small conductive gate line. Three rightmost dotted P-electrodes 2 are also connected by a same small conductive gate line. An insulating medium 6 is further provided on the cell, and the conversion efficiency of the cell is 23.2%.

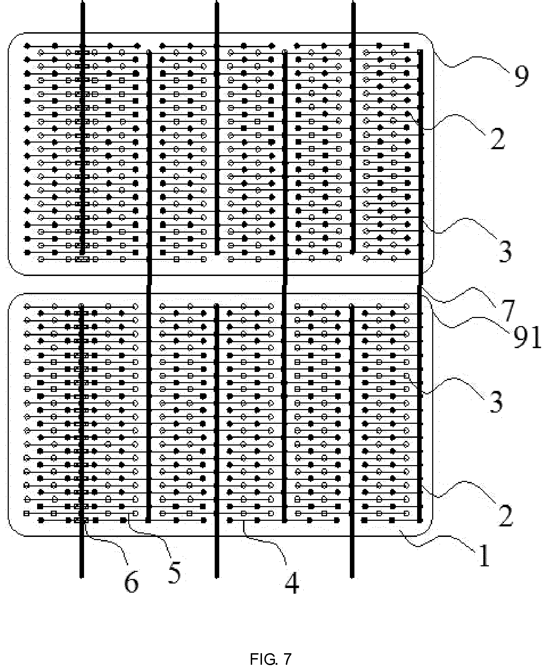

Fig. 7 shows a back schematic view of the series connection of dotted busbar-free and high-efficiency back-contact solar cells. Leads 7 are further provided on an electrical connection layer of the busbar-free and high-efficiency back-contact solar cell module. The leads 7 connect a number of small conductive gate lines connected to the P-electrodes or connect the P-electrodes, and the leads 7 connect a number of small conductive gate lines connected to the N-electrodes or connect the N-electrodes. A number of adjacent dotted P-electrodes 2 or dotted N-electrodes 3 converge the current by the small conductive gate lines, and the collected current is exported by the leads 7. Preferably, the leads 7 are vertically connected to a center line of the number of small conductive gate lines. The leads 7 and the small conductive gate lines form " 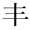 "-shaped structures or comb-finger structures, which are arranged crosswise. The junctions of the small conductive gate lines and the leads 7 are electrically insulated by the insulating medium 6.

This embodiment further provides a busbar-free and high-efficiency back-contact solar cell assembly, comprising fronting material, packaging material, a solar cell layer, packaging material and backing material, which are connected from top to bottom, wherein the solar cell layer comprises a number of solar cell modules, and the solar cell module refer to the above solar cell module.

A method for preparing a busbar-free and high-efficiency back-contact solar cell assembly is provided, comprising the following steps.

Step 1: Solar cell modules are connected in series to form a solar cell layer, an electrical connection layer on a backlight side of each of the solar cell modules having a number of small conductive gate lines connected to P-electrodes and a number of small conductive gate lines connected to N-electrodes, and the small conductive gate lines being of a multi-section structure; a number of leads 7 are electrically connected to P-electrodes or small conductive gate lines connected to the P-electrodes in a third solar cell 9, and a fourth solar cell 91 is aligned with the third solar cell 9 so that P-electrodes on the fourth solar cell 91 and N-electrodes on the third solar cell 9 are on a same lead 7; the leads 7 are electrically connected to N-electrodes or small conductive gate lines connected to the N-electrodes in the fourth solar cell 91 so that the fourth solar cell 91 and the third solar cell 9 are connected in series; and, the third solar cell 9 is placed, the leads 7 are electrically connected to the third solar cell 9, the above operations are repeated to form a series connection structure, so as to form a solar cell layer.

In this embodiment, the connection is realized by welding. In this embodiment, the leads 7 plated with low-melting-point material are used. The low-melting-point material is any one of tin solder, tin-lead alloy, tin-bismuth alloy or tin-lead-silver alloy. The plating process is any one of hot dip coating, electroplating or chemical plating, preferably tin solder electroplating in this embodiment. When heated, the leads 7 and the P-type doping layer or the N-type doping layer are welded by the melting of the low-melting-point material to form the P-electrodes and the N-electrodes, and in this way the leads 7 and the solar cells are electrically connected. The temperature for welding is 300°C to 400°C, preferably 350°C in this embodiment. In the welding process, a heating pad can be used on the front side of the cell, in order to prevent the cell from breaking or hidden-cracking due to a big temperature difference on the two sides of the cell. The temperature of the heating pad is controlled at 40°C to 80°C, preferably 40°C in this embodiment. The heating way is any one or more of infrared radiation, heating by resistance wires or heating by hot wind, and the heating temperature is 150°C to 500°C, preferably 150°C in this embodiment. A process for preparing the small conductive gate lines is as follows: printing silver paste on the solar cells in segments by screen printing, drying small gate lines of the solar cells having silver paste electrodes printed thereon, and sintering as a whole to obtain a solar cell module with a number of small conductive gate lines. The small conductive gate lines connect three, five or seven points, as shown in Fig. 7.

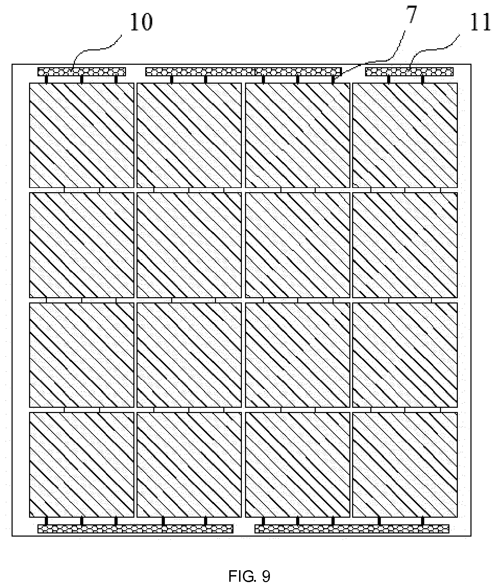

Step 2: The manufactured solar cell layers are connected in series by using conventional and general busbars having a cross-sectional area of 5× 0.22 mm. The number of the solar cells is selected as desired. In this embodiment, 32 solar cells are selected. Glass, EVA, the solar cell layer, EVA and backing material are successively stacked, and the appearance inspection is performed, wherein the well-stacked module is put into a laminating press for lamination, and parameters for the laminating operation are set according to the vulcanizing properties of the EVA, usually, laminating for 9 min at 180°C. At last, a metal frame and a terminal box are mounted on the laminated module, and then power test and appearance inspection are performed. Hence, a solar cell assembly is obtained, as shown in Fig. 9.

The above back-contact assembly having 32 solar cells has the following power parameters:
open-circuit voltage: Uoc (V) 22.25;
short-circuit current: Isc (A) 9.25;
working voltage: Ump (V) 17.27;
working current: Imp (A) 9.08;
maximum power: Pmax (W) 156.78; and
filling factor: 76.18%.

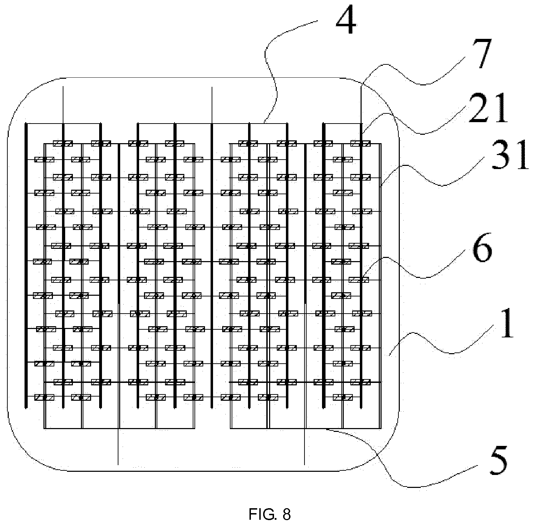

Similarly, the dotted electrodes of the solar cells in this embodiment can be replaced with linear electrodes. A main difference lies in that junctions of the small conductive gate lines and the linear electrodes need to be insulated by an insulating medium 6. Fig. 8 shows a busbar-free and high-efficiency back-contact solar cell, wherein there are 10 rows of linear P-electrodes 21 and 10 rows of linear N-electrodes 31. The width of the linear P-electrodes 21 is 0.4 mm to 1.5 mm, and the width of the linear N-electrodes 31 is 0.4 mm to 1.5 mm. The small conductive gate lines are interdigitally arranged in parallel. The number of linear electrodes interconnected by each conductive gate line may be 2, 3, 5, 7, 9, 11, 13, 15 or 17, preferably 2, 3 or 5 in this embodiment. Every five linear N-electrodes 31 are connected by the small conductive gate lines. The small conductive gate lines are made of sintered silver paste or leads 7, preferably small conductive gate lines in this embodiment. Each of the small conductive gate lines has a width of 10 µm to 300 µm and a width-to-height ratio of 1:0.01 to 1:1. In this embodiment, preferably, each of the small conductive gate lines has a width of 300 µm. Three leftmost linear P-electrodes 21 are connected by a small conductive gate line which is made of sintered silver paste and has a width of 30 µm. Five middle linear P-electrodes 21 are also connected by a same small conductive gate line. Two rightmost linear P-electrodes 21 are also connected by a same small conductive gate line. An insulating medium 6 is further provided on the cell, and the conversion efficiency of the cell is 23.2%.

In another embodiment, a structure having both dotted electrodes and linear electrodes may also be adopted. The principle thereof is similar to the above embodiments and will not be repeated here.

It can be known from the experiment parameters in the embodiments that a solar cell assembly formed by the back-contact solar cell modules produced by the present application can obtain a high filling factor. Accordingly, the power generation efficiency of the assembly is improved. The short-circuiting between P-electrodes and N-electrodes can be effectively prevented. The present application also has the advantages of hidden-cracking resistance, high efficiency, high stability, simple preparation process and greatly reduced cost.

In the embodiments of the present application, the distinction between the busbar-free and high-efficiency back-contact solar cells (the first solar cell and the second solar cell in Embodiment 1, and the third solar cell and the fourth solar cell in Embodiment 2) is merely for ease of description, and the distinction between the cells forming the electrode structures of two back-contact solar cell doping layers is not limited in sequence. The distinction is for easily understanding the embodiments of the present application, and not intended to limit the protection scope of the present application. The first solar cell may also be called a primary cell, and the second solar cell may also be called a secondary cell. In Embodiment 1, there are total X-1 rows of P-electrodes (Y P-electrodes in each row) and X rows of N-electrodes (Y N-electrodes in each row) in the first solar cell, and total X-1 rows of N-electrodes (Y N-electrodes in each row) and X rows of P-electrodes (Y P-electrodes in each row) in the second solar cell, where both X and Y are integers greater than 2.

## Claims

1. A busbar-free and high-efficiency back-contact solar cell module, comprising solar cells (1) and an electrical connection layer, a rear side of the solar cells having P-electrodes connected to a P-type doping layer and N-electrodes connected to an N-type doping layer, wherein the electrical connection layer comprises a number of conductive fingers, part of which are connected to the P-electrodes on the rear side of the solar cells while the other part of which are connected to the N-electrodes on the rear side of the solar cells; and the conductive fingers are of a multi-section structure,
wherein the conductive fingers are made of sintered silver paste or leads, and each of the conductive fingers has a width of 10 µm to 300 µm and a width-to-height ratio of 1:0.01 to 1:1,
wherein the P-electrodes are dotted P-electrodes (2), and the N-electrodes are dotted N-electrodes (3); and, there are 2 to 17 dotted electrodes interconnected by each conductive finger;
wherein the conductive fingers are interdigitally arranged in parallel;
wherein leads (7) are provided in the electrical connection layer; the leads (7) connect the P-electrodes; and the leads (7) connect the N-electrodes;
wherein the leads (7) and the fingers form structures shaped as comb with fingers on both sides, which are arranged crosswise.

2. The busbar-free and high-efficiency back-contact solar cell module according to claim 1, wherein the diameter of the dotted P-electrodes (2) is 0.2 mm to 1.5 mm, the distance between two adjacent dotted P-electrodes (2) connected to a same conductive finger is 0.7 mm to 10 mm, the diameter of the dotted N-electrodes (3) is 0.2 mm to 1.5 mm, the distance between two adjacent dotted N-electrodes (3) connected on a same conductive finger is 0.7 mm to 10 mm, and, the total number of the dotted P-electrodes (2) and the dotted N-electrodes (3) is 1000 to 40000.

3. The busbar-free and high-efficiency back-contact solar cell module according to claim 1, wherein an insulating medium (6) capable of preventing the electrodes from conduction is provided between the P-electrodes and the N-electrodes of the solar cells, between the electrodes in the doping layers of the cells and the fingers or between the fingers.

4. The busbar-free and high-efficiency back-contact solar cell module according to claim 1, wherein the dotted electrodes are made of any one of sliver paste, conductive adhesive, conductive polymeric material or tin solder.

5. The busbar-free and high-efficiency back-contact solar cell module according to claim 1, wherein there are 2, 3, 5, 7, 9, 11, 13, 15 or 17 dotted electrodes interconnected by each conductive finger.

6. The busbar-free and high-efficiency back-contact solar cell module according to claim 1, wherein the leads (7) are vertically connected to a center line of the number of conductive fingers.

7. The busbar-free and high-efficiency back-contact solar cell module according to claim 1, wherein the surfaces of the leads (7) are plated with anti-oxidation plating material or coated with a conductive adhesive; the anti-oxidation plating material is any one of tin, tin-lead alloy, tin-bismuth alloy or tin-lead-silver alloy; the plating layer or conductive adhesive layer of the leads (7) has a thickness of 5 µm to 50 µm; the conductive adhesive is a low-resistivity conductive adhesive that uses a conductive particle and a polymeric binder as main components; the conductive particle in the conductive adhesive is any one or more of gold, silver, copper, gold-plated nickel, silver-plated nickel or silver-plated copper, the shape of the conductive particles are any one of a spherical shape, a flake shape, an olivary shape or an acicular shape, and the particle size of the conductive particle is 0.01 µm to 5 µm; and, the polymeric binder in the conductive adhesive is any one or more of epoxy resin, polyurethane resin, acrylic resin or organic silicon resin, and the binder is thermosetting or photocureable.

8. The busbar-free and high-efficiency back-contact solar cell module according to claim 1, wherein the electrical connection layer is provided with P-bus conductor electrodes (10) and N-bus conductor electrodes (11), which are arranged on two sides of the electrical connection layer; and, the surface of the bus conductor electrodes has a concavo-convex shape.

9. The busbar-free and high-efficiency back-contact solar cell module according to claim 2, wherein the insulating medium (6) is a thermoplastic resin or a thermosetting resin, and the resin is any one or more of polyimide, polycaprolactam, polyolefin resin, epoxy resin, polyurethane resin, acrylic resin and organic silicon resin.

10. A busbar-free and high-efficiency back-contact solar cell assembly, comprising fronting material, packaging material, a solar cell layer, packaging material and backing material, which are connected from top to bottom, wherein the solar cell layer comprises a number of solar cell modules, and the solar cell modules refer to the solar cell module according to any one of claims 1 to 9.

11. The busbar-free and high-efficiency back-contact solar cell assembly according to claim 9, wherein the solar cell modules in the solar cell layer are connected via bus conductors arranged on two sides of an electrical connection layer.

12. The busbar-free and high-efficiency back-contact solar cell assembly according to any one of claims 8 to 11, wherein the number of solar cells in the solar cell assembly is 1 to 120.

13. A method for preparing a busbar-free and high-efficiency back-contact solar cell assembly, comprising the following steps:
Step 1: connecting solar cell modules in claim 1 in series to form a solar cell layer, electrically connecting a number of leads to electrodes or conductive fingers of a first solar cell, and aligning a second solar cell with the first solar cell so that P-electrodes on the second solar cell and N-electrodes on the first solar cell are on a same lead; and, electrically connecting the leads (7) to electrodes or conductive fingers of the second solar cell, and repeating the above operations to form a series connection structure, so as to form a solar cell layer
and
Step 2: successively stacking and laminating fronting material, packaging material, the solar cell layer, packaging material and backing material to obtain a solar cell assembly.

14. The method for preparing a busbar-free and high-efficiency back-contact solar cell assembly according to claim 13, wherein a solar cell string is prepared in accordance with the Step 1, and the solar cell string comprises at least one solar cell; and, busbar electrodes are arranged on two sides of the solar cell string, and the busbar electrodes are connected in series to form a solar cell layer.

15. The method for preparing a busbar-free and high-efficiency back-contact solar cell assembly according to any one of claims 13 to 14, wherein a process for preparing the conductive fingers is as follows: printing silver paste on the solar cells in segments by screen printing, drying fingers of the solar cells having silver paste electrodes printed thereon, and sintering as a whole to obtain a solar cell module with a number of conductive fingers.

16. The method for preparing a busbar-free and high-efficiency back-contact solar cell assembly according to any one of claims 13 to 14, wherein parameters for the laminating operation are set according to the vulcanizing properties of the packaging material; and, the packaging material is EVA and the parameters for the laminating operation are as follows: laminating 9 to 35 min at 120°C to 180°C.

17. The method for preparing a busbar-free and high-efficiency back-contact solar cell assembly according to any one of claims 13 to 14, wherein the solar cells and the leads (7) in the Step 1 are electrically connected by coating conductive adhesive on a P-type doping layer and an N-type doping layer on the cells by screen printing; the conductive adhesive, when heated, can be solidified to form the P-electrodes and the N-electrodes; and, when heated, the leads and the P-electrodes or the N-electrodes come into Ohm contact by the conductive adhesive, and in this way, the leads (7) and the cells are electrically connected;
the solar cells and the leads (7) are also electrically connected by plating low-melting-point material on the leads by a plating process; when heated, the leads and the P-type doping layer or the N-type doping layer are welded by the melting of the low-melting-point material to form the P-electrodes and the N-electrodes, and in this way the leads and the solar cells are electrically connected; and the low-melting-point material is any one of tin solder, tin-lead alloy, tin-bismuth alloy or tin-lead-silver alloy; and
the solar cells and the leads can also be electrically connected by laser welding.

## Patentansprüche

1. Busbarloses und hocheffizientes Rückkontakt-Solarzellenmodul, umfassend Solarzellen (1) und eine elektrische Verbindungsschicht, wobei eine Rückseite der Solarzellen P-Elektroden, welche mit einer Dotierungsschicht vom P-Typ verbunden sind, und N-Elektroden aufweist, welche mit einer Dotierungsschicht vom N-Typ verbunden sind, wobei die elektrische Verbindungsschicht eine Anzahl leitfähiger Finger umfasst, von welchen ein Teil mit den P-Elektroden an der Rückseite der Solarzellen verbunden ist, während der andere Teil davon mit den N-Elektroden an der Rückseite der Solarzellen verbunden ist; und wobei die leitfähigen Finger von einer mehrteiligen Struktur sind,
wobei die leitfähigen Finger aus gesinterter Silberpaste oder aus Leitungen hergestellt sind und wobei jeder der leitfähigen Finger eine Breite von 10 µm bis 300 µm und ein Breite-zu-Höhe-Verhältnis von 1:0,01 bis 1:1 aufweist,
wobei die P-Elektroden dotierte P-Elektroden (2) sind und die N-Elektroden dotierte N-Elektroden (3) sind; und wobei 2 bis 17 dotierte Elektroden vorhanden sind, welche durch jeden leitfähigen Finger miteinander verbunden sind;
wobei die leitfähigen Finger interdigital parallel angeordnet sind;
wobei Leitungen (7) in der elektrischen Verbindungsschicht bereitgestellt sind; wobei die Leitungen (7) die P-Elektroden verbinden; und wobei die Leitungen (7) die N-Elektroden verbinden;
wobei die Leitungen (7) und die Finger Strukturen bilden, welche als Kamm mit Fingern an beiden Seiten geformt sind, die kreuzweise angeordnet sind.

2. Busbarloses und hocheffizientes Rückkontakt-Solarzellenmodul nach Anspruch 1, wobei der Durchmesser der dotierten P-Elektroden (2) 0,2 mm bis 1,5 mm beträgt, der Abstand zwischen zwei benachbarten dotierten P-Elektroden (2), welche mit einem gleichen leitfähigen Finger verbunden sind, 0,7 mm bis 10 mm beträgt, der Durchmesser der dotierten N-Elektroden (3) 0,2 mm bis 1,5 mm beträgt, der Abstand zwischen zwei benachbarten dotierten N-Elektroden (3), welche an einem gleichen leitfähigen Finger verbunden sind, 0,7 mm bis 10 mm beträgt und die gesamte Anzahl der dotierten P-Elektroden (2) und der dotierten N-Elektroden (3) 1000 bis 40000 beträgt.

3. Busbarloses und hocheffizientes Rückkontakt-Solarzellenmodul nach Anspruch 1, wobei ein isolierendes Medium (6), welches dazu in der Lage ist, eine Leitung der Elektroden zu verhindern, zwischen den P-Elektroden und den N-Elektroden der Solarzellen, zwischen den Elektroden in den Dotierungsschichten der Zellen und der Finger oder zwischen den Fingern bereitgestellt ist.

4. Busbarloses und hocheffizientes Rückkontakt-Solarzellenmodul nach Anspruch 1, wobei die dotierten Elektroden aus irgendeinem aus Silberpaste, einem leitfähigen Klebstoff, einem leitfähigen Polymermaterial oder Lötzinn hergestellt sind.

5. Busbarloses und hocheffizientes Rückkontakt-Solarzellenmodul nach Anspruch 1, wobei 2, 3, 5, 7, 9, 11, 13, 15 oder 17 dotierte Elektroden vorhanden sind, welche durch jeden leitfähigen Finger miteinander verbunden sind.

6. Busbarloses und hocheffizientes Rückkontakt-Solarzellenmodul nach Anspruch 1, wobei die Leitungen (7) vertikal mit einer Mittellinie der Anzahl leitfähiger Finger verbunden sind.

7. Busbarloses und hocheffizientes Rückkontakt-Solarzellenmodul nach Anspruch 1, wobei die Oberflächen der Leitungen (7) mit einem Anti-Oxidation-Plattierungsmaterial plattiert sind oder mit einem leitfähigen Klebstoff beschichtet sind; wobei das Anti-Oxidation-Plattierungsmaterial irgendeines ist aus Zinn, einer Zinn-Blei-Legierung, einer Zinn-Wismut-Legierung oder einer Zinn-Blei-Silber-Legierung; wobei die Plattierungsschicht oder die leitfähige Klebstoffschicht der Leitungen (7) eine Dicke von 5 µm bis 50 µm aufweist; wobei der leitfähige Klebstoff ein leitfähiger Klebstoff mit niedrigem spezifischen Widerstand ist, welcher ein leitfähiges Partikel und ein polymeres Bindemittel als Hauptkomponenten verwendet; wobei das leitfähige Partikel in dem leitfähigen Klebstoff irgendeines oder mehrere ist aus Gold, Silber, Kupfer, vergoldetem Nickel, versilbertem Nickel oder versilbertem Kupfer, die Form der leitfähigen Partikel irgendeine ist aus einer kugelförmigen Form, einer Flockenform, einer Olivary-Form oder einer nadelförmigen Form und die Partikelgröße des leitfähigen Partikels 0,01 µm bis 5 µm beträgt; und wobei das polymere Bindemittel in dem leitfähigen Klebstoff irgendeines oder mehrere ist aus Epoxidharz, Polyurethanharz, Acrylharz oder organischem Siliziumharz und das Bindemittel wärmehärtbar oder photohärtbar ist.

8. Busbarloses und hocheffizientes Rückkontakt-Solarzellenmodul nach Anspruch 1, wobei die elektrische Verbindungsschicht mit P-Bus-Leiterelektroden (10) und N-Bus-Leiterelektroden (11) bereitgestellt ist, welche an zwei Seiten der elektrischen Verbindungsschicht angeordnet sind; und wobei die Oberfläche der Bus-Leiterelektroden eine konkav-konvexe Form aufweist.

9. Busbarloses und hocheffizientes Rückkontakt-Solarzellenmodul nach Anspruch 2, wobei das isolierende Medium (6) ein thermoplastisches Harz oder ein wärmehärtbares Harz ist und wobei das Harz irgendeines oder mehreres ist aus Polyimid, Polycaprolactam, Polyolefinharz, Epoxidharz, Polyurethanharz, Acrylharz und organischem Siliziumharz.

10. Busbarlose und hocheffiziente Rückkontakt-Solarzellenanordnung, umfassend Fronting-Material, Verpackungsmaterial, eine Solarzellenschicht, Verpackungsmaterial und Trägermaterial, welche von oben nach unten verbunden sind, wobei die Solarzellenschicht eine Anzahl von Solarzellenmodulen umfasst und die Solarzellemodule das Solarzellenmodul nach einem der Ansprüche 1 bis 9 betreffen.

11. Busbarlose und hocheffiziente Rückkontakt-Solarzellenanordnung nach Anspruch 9, wobei die Solarzellenmodule in der Solarzellenschicht über Bus-Leiter verbunden sind, welche an zwei Seiten einer elektrischen Verbindungsschicht angeordnet sind.

12. Busbarlose und hocheffiziente Rückkontakt-Solarzellenanordnung nach einem der Ansprüche 8 bis 11, wobei die Anzahl von Solarzellen in der Solarzellenanordnung 1 bis 120 beträgt.

13. Verfahren zum Vorbereiten einer busbarlosen und hocheffizienten Rückkontakt-Solarzellenanordnung, umfassend die folgenden Schritte:
Schritt 1: Verbinden von Solarzellenmodulen in Anspruch 1 in Reihe, um eine Solarzellenschicht zu bilden, elektrisch Verbinden einer Anzahl von Leitungen mit Elektroden oder leitfähigen Fingern einer ersten Solarzelle und Ausrichten einer zweiten Solarzelle mit der ersten Solarzelle, so dass P-Elektroden an der zweiten Solarzelle und N-Elektroden an der ersten Solarzelle an einer gleichen Leitung liegen; und elektrisch Verbinden der Leitungen (7) mit Elektroden oder leitfähigen Fingern der zweiten Solarzelle und Wiederholen der obigen Vorgänge, um eine Reihenverbindungsstruktur zu bilden, um eine Solarzellenschicht zu bilden;
und
Schritt 2: sukzessive Stapeln und Laminieren von Fronting-Material, Verpackungsmaterial, der Solarzellenschicht, Verpackungsmaterial und Trägermaterial, um eine Solarzellenanordnung zu erhalten.

14. Verfahren zum Vorbereiten einer busbarlosen und hocheffizienten Rückkontakt-Solarzellenanordnung nach Anspruch 13, wobei ein Solarzellenstring im Einklang mit dem Schritt 1 vorbereitet wird und der Solarzellenstring wenigstens eine Solarzelle umfasst; und wobei Busbar-Elektroden an zwei Seiten des Solarzellenstrings angeordnet sind und die Busbar-Elektroden in Reihe verbunden sind, um eine Solarzellenschicht zu bilden.

15. Verfahren zum Vorbereiten einer busbarlosen und hocheffizienten Rückkontakt-Solarzellenanordnung nach einem der Ansprüche 13 bis 14, wobei sich ein Prozess zum Vorbereiten der leitfähigen Finger wie folgt darstellt: Drucken von Silberpaste auf die Solarzellen in Segmenten durch Siebdrucken, Trocknen von Fingern der Solarzellen, auf welchen Silberpaste-Elektroden gedruckt sind, und Sintern als ein Ganzes, um ein Solarzellenmodul mit einer Anzahl leitfähiger Finger zu erhalten.

16. Verfahren zum Vorbereiten einer busbarlosen und hocheffizienten Rückkontakt-Solarzellenanordnung nach einem der Ansprüche 13 bis 14, wobei Parameter für den Laminierungsvorgang gemäß den Vulkanisierungseigenschaften des Verpackungsmaterials eingestellt werden; und wobei das Verpackungsmaterial EVA ist und sich die Parameter für den Laminierungsvorgang wie folgt darstellen: Laminieren für 9 bis 35 Min. bei 120 °C bis 180 °C.

17. Verfahren zum Vorbereiten einer busbarlosen und hocheffizienten Rückkontakt-Solarzellenanordnung nach einem der Ansprüche 13 bis 14, wobei die Solarzellen und die Leitungen (7) in dem Schritt 1 durch Auftragen eines leitfähigen Klebstoffs auf eine Dotierungsschicht vom P-Typ und eine Dotierungsschicht vom N-Typ auf den Zellen durch Siebdrucken elektrisch verbunden werden; wobei sich der leitfähige Klebstoff, wenn erwärmt, verfestigen kann, um die P-Elektroden und die N-Elektroden zu bilden; und wobei, wenn erwärmt, die Leitungen und die P-Elektroden oder die N-Elektroden durch den leitfähigen Klebstoff in Ohm-Kontakt gelangen und auf diese Weise die Leitungen (7) und die Zellen elektrisch verbunden werden;
wobei die Solarzellen und die Leitungen (7) auch durch Plattieren von Material mit niedrigem Schmelzpunkt auf die Leitungen durch einen Plattierungsprozess elektrisch verbunden werden; wobei, wenn erwärmt, die Leitungen und die Dotierungsschicht vom P-Typ oder die Dotierungsschicht vom N-Typ durch das Schmelzen des Materials mit niedrigem Schmelzpunkt geschweißt werden, um die P-Elektroden und die N-Elektroden zu bilden, und auf diese Weise die Leitungen und die Solarzellen elektrisch verbunden werden; und wobei das Material mit niedrigem Schmelzpunkt irgendeines ist aus Lötzinn, einer Zinn-Blei-Legierung, einer Zinn-Wismut-Legierung oder einer Zinn-Blei-Silber-Legierung; und
wobei die Solarzellen und die Leitungen auch durch Laserschweißen elektrisch verbunden werden können.

## Revendications

1. Module de cellule solaire à contact arrière à haut rendement et sans barre omnibus, comprenant des cellules solaires (1) et une couche de connexion électrique, un côté arrière des cellules solaires ayant des électrodes P connectées à une couche de dopage de type P et des électrodes N connectées à une couche de dopage de type N, dans lequel la couche de connexion électrique comprend de nombreux doigts conducteurs, une partie desquels sont connectés aux électrodes P sur le côté arrière des cellules solaires tandis que l'autre partie desquels sont connectés aux électrodes N sur le côté arrière des cellules solaires ; et les doigts conducteurs sont d'une structure à sections multiples,
dans lequel les doigts conducteurs sont constitués de pâte d'argent frittée ou de fils, et chacun des doigts conducteurs présente une largeur de 10 µm à 300 µm et un rapport largeur sur hauteur de 1:0,01 à 1:1,
dans lequel les électrodes P sont des électrodes P à points (2), et les électrodes N sont des électrodes N à points (3) ; et, il y a 2 à 17 électrodes à points interconnectées par chaque doigt conducteur ;
dans lequel les doigts conducteurs sont agencés de manière entrecroisée en parallèle ; dans lequel des fils (7) sont prévus dans la couche de connexion électrique ; les fils (7) connectent les électrodes P ; et les fils (7) connectent les électrodes N ;
dans lequel les fils (7) et les doigts forment des structures façonnées comme un peigne doté de doigts sur les deux côtés, qui sont agencés en croix.

2. Module de cellule solaire à contact arrière à haut rendement et sans barre omnibus selon la revendication 1, dans lequel le diamètre des électrodes P à points (2) est de 0,2 mm à 1,5 mm, la distance entre deux électrodes P à points (2) adjacentes connectées à un même doigt conducteur est de 0,7 mm à 10 mm, le diamètre des électrodes N à points (3) est de 0,2 mm à 1,5 mm, la distance entre deux électrodes N à points (3) adjacentes connectées sur un même doigt conducteur est de 0,7 mm à 10 mm, et, le nombre total des électrodes P à points (2) et des électrodes N à points (3) est de 1 000 à 40 000.

3. Module de cellule solaire à contact arrière à haut rendement et sans barre omnibus selon la revendication 1, dans lequel un milieu isolant (6) capable d'empêcher une conduction des électrodes est prévu entre les électrodes P et les électrodes N des cellules solaires, entre les électrodes dans les couches de dopage des cellules et les doigts ou entre les doigts.

4. Module de cellule solaire à contact arrière à haut rendement et sans barre omnibus selon la revendication 1, dans lequel les électrodes à points sont constituées de l'un quelconque parmi une pâte d'argent, un adhésif conducteur, un matériau polymère conducteur ou une soudure à l'étain.

5. Module de cellule solaire à contact arrière à haut rendement et sans barre omnibus selon la revendication 1, dans lequel il y a 2, 3, 5, 7, 9, 11, 13, 15 ou 17 électrodes à points interconnectées par chaque doigt conducteur.

6. Module de cellule solaire à contact arrière à haut rendement et sans barre omnibus selon la revendication 1, dans lequel les fils (7) sont verticalement connectés à une ligne centrale des nombreux doigts conducteurs.

7. Module de cellule solaire à contact arrière à haut rendement et sans barre omnibus selon la revendication 1, dans lequel les surfaces des fils (7) sont plaquées avec un matériau de placage antioxydation ou revêtues avec un adhésif conducteur ; le matériau de placage antioxydation est l'un quelconque parmi l'étain, un alliage étain-plomb, un alliage étain-bismuth ou un alliage étain-plomb-argent ; la couche de placage ou la couche d'adhésif conducteur des fils (7) présente une épaisseur de 5 µm à 50 µm ; l'adhésif conducteur est un adhésif conducteur à faible résistivité qui utilise une particule conductrice et un liant polymère en tant que constituants principaux ; la particule conductrice dans l'adhésif conducteur est l'un quelconque ou plusieurs parmi en or, en argent, en cuivre, en nickel plaqué or, en nickel plaqué argent ou en cuivre plaqué argent, la forme des particules conductrices est l'une quelconque parmi une forme sphérique, une forme de flocon, une forme olivaire ou une forme aciculaire, et la taille particulaire de la particule conductrice est de 0,01 µm à 5 µm ; et, le liant polymère dans l'adhésif conducteur est l'une quelconque ou plusieurs parmi une résine époxy, une résine polyuréthane, une résine acrylique ou une résine de silicium organique, et le liant est thermodurcissable ou photoréticulable.

8. Module de cellule solaire à contact arrière à haut rendement et sans barre omnibus selon la revendication 1, dans lequel la couche de connexion électrique est munie d'électrodes de conducteur de bus P (10) et d'électrodes de conducteur de bus N (11), qui sont agencées sur les deux côtés de la couche de connexion électrique ; et, la surface des électrodes de conducteur de bus présente une forme concavo-convexe.

9. Module de cellule solaire à contact arrière à haut rendement et sans barre omnibus selon la revendication 2, dans lequel le milieu isolant (6) est une résine thermoplastique ou une résine thermodurcissable, et la résine est l'un quelconque ou plusieurs parmi un polyimide, un polycaprolactame, une résine polyoléfine, une résine époxy, une résine polyuréthane, une résine acrylique et une résine de silicium organique.

10. Ensemble de cellules solaires à contact arrière à haut rendement et sans barre omnibus, comprenant un matériau de façade, un matériau de conditionnement, une couche de cellules solaires, un matériau de conditionnement et un matériau de support, qui sont reliés de haut en bas, dans lequel la couche de cellules solaires comprend de nombreux modules de cellules solaires, et les modules de cellules solaires se réfèrent au module de cellule solaire selon l'une quelconque des revendications 1 à 9.

11. Ensemble de cellules solaires à contact arrière à haut rendement et sans barre omnibus selon la revendication 9, dans lequel les modules de cellules solaires dans la couche de cellules solaires sont connectés via des conducteurs de bus agencés sur deux côtés d'une couche de connexion électrique.

12. Ensemble de cellules solaires à contact arrière à haut rendement et sans barre omnibus selon l'une quelconque des revendications 8 à 11, dans lequel le nombre de cellules solaires dans l'ensemble de cellules solaires est de 1 à 120.

13. Procédé pour la préparation d'un ensemble de cellules solaires à contact arrière à haut rendement et sans barre omnibus, comprenant les étapes suivantes :
Étape 1 : connecter des modules de cellules solaires selon la revendication 1 en série pour former une couche de cellules solaires, connecter électriquement de nombreux fils à des électrodes ou des doigts conducteurs d'une première cellule solaire, et aligner une deuxième cellule solaire avec la première cellule solaire de sorte que des électrodes P sur la deuxième cellule solaire et des électrodes N sur la première cellule solaire soient sur un même fil ; et, connecter électriquement les fils (7) à des électrodes ou des doigts conducteurs de la deuxième cellule solaire, et répéter les opérations ci-dessus pour former une structure de connexion en série, de façon à former une couche de cellules solaires ; et
Étape 2 : empiler et stratifier successivement un matériau de façade, un matériau de conditionnement, la couche de cellules solaires, un matériau de conditionnement et un matériau de support pour obtenir un ensemble de cellules solaires.

14. Procédé pour la préparation d'un ensemble de cellules solaires à contact arrière à haut rendement et sans barre omnibus selon la revendication 13, dans lequel une chaîne de cellules solaires est préparée conformément à l'étape 1, et la chaîne de cellules solaires comprend au moins une cellule solaire ; et, des électrodes de barre omnibus sont agencées sur deux côtés de la chaîne de cellules solaires, et les électrodes de barre omnibus sont connectées en série pour former une couche de cellules solaires.

15. Procédé pour la préparation d'un ensemble de cellules solaires à contact arrière à haut rendement et sans barre omnibus selon l'une quelconque des revendications 13 à 14, dans lequel un processus pour la préparation des doigts conducteurs est comme suit : imprimer de la pâte d'argent sur les cellules solaires en segments par sérigraphie, sécher des doigts des cellules solaires ayant des électrodes en pâte d'argent imprimées sur ceux-ci, et fritter en totalité pour obtenir un module de cellule solaire doté de nombreux doigts conducteurs.

16. Procédé pour la préparation d'un ensemble de cellules solaires à contact arrière à haut rendement et sans barre omnibus selon l'une quelconque des revendications 13 à 14, dans lequel des paramètres pour l'opération de stratification sont définis selon les propriétés de vulcanisation du matériau de conditionnement ; et, le matériau de conditionnement est l'éthylène-acétate de vinyle (EVA) et les paramètres pour l'opération de stratification sont comme suit : stratifier pendant 9 à 35 min à une température de 120°C à 180 °C.

17. Procédé pour la préparation d'un ensemble de cellules solaires à contact arrière à haut rendement et sans barre omnibus selon l'une quelconque des revendications 13 à 14, dans lequel les cellules solaires et les fils (7) à l'étape 1 sont électriquement connectés en revêtant un adhésif conducteur sur une couche de dopage de type P et une couche de dopage de type N sur les cellules par sérigraphie ; l'adhésif conducteur, lorsqu'il est chauffé, peut être solidifié pour former les électrodes P et les électrodes N ; et, lorsqu'ils sont chauffés, les fils et les électrodes P ou les électrodes N viennent en contact ohmique grâce à l'adhésif conducteur, et de cette manière, les fils (7) et les cellules sont électriquement connectés ;
les cellules solaires et les fils (7) sont également électriquement connectés en plaquant un matériau à bas point de fusion sur les fils par un processus de placage ; lorsqu'ils sont chauffés, les fils et la couche de dopage de type P ou la couche de dopage de type N sont soudés par la fusion du matériau à bas point de fusion pour former les électrodes P et les électrodes N, et de cette manière les fils et les cellules solaires sont électriquement connectés ; et le matériau à bas point de fusion est l'un quelconque parmi une soudure à l'étain, un alliage étain-plomb, un alliage étain-bismuth ou un alliage étain-plomb-argent ; et
les cellules solaires et les fils peuvent également être électriquement connectés par soudage au laser.
